# EUROPÄISCHE PATENTSCHRIFT

(11) **EP 3 921 609 B1**
(45) Veröffentlichungstag und Bekanntmachung des Hinweises auf die Patenterteilung: **12.07.2023**
(21) Anmeldenummer: 20704455.3
(22) Anmeldetag: 04.02.2020
(51) Int. Cl.: G01G 21/28, G01G 23/48

(54) **GRAVIMETRISCHES MESSSYSTEM**
GRAVIMETRIC MEASURING SYSTEM
SYSTÈME DE MESURE GRAVIMÉTRIQUE

(30) Priorität: 05.02.2019 DE 102019102810
(43) Veröffentlichungstag der Anmeldung: 15.12.2021
(73) Patentinhaber: Sartorius Lab Instruments GmbH & Co. KG, 37079 Göttingen (DE)
(72) Erfinder: FELDOTTE, Heinrich, 37079 Göttingen (DE); LAUBSTEIN, Michael, 37077 Göttingen (DE); VON STEUBEN, Jan, 37075 Göttingen (DE); STÄNDER, Malte, 37308 Heiligenstadt (DE); HOLST, Heyko, 37085 Göttingen (DE)
(74) Vertreter: Novagraaf International SA
(86) Internationale Anmeldenummer: PCT/EP2020/052678
(87) Internationale Veröffentlichungsnummer: WO 2020/161103

(56) Entgegenhaltungen:
- EP-A1- 1 312 902
- EP-A1- 1 367 372
- DE-A1-102014 101 558
- DE-B4-102009 055 622
- JP-A- H0 228 522

## Beschreibung

### Gebiet der Erfindung

Die Erfindung betrifft ein gravimetrisches Messsystem, umfassend
- eine Waage mit einem von einer Mehrzahl von Wägeraumwänden umgebenen Wägeraum, einem von einem angrenzenden Wägesystemraum umschlossenen, elektromechanischen Wägesystem und einer elektronischen Steuereinrichtung zur Steuerung des Systembetriebs gemäß in ihrem Speicher hinterlegten Regeln sowie
- eine Mehrzahl von bei Betrieb Wärme generierenden Funktionsmodulen, die bedarfsweise in an wenigstens einer Wägeraumwand angeordnete Modulaufnahmen einsetzbar sind.

### Stand der Technik

Derartige gravimetrische Messsysteme sind bekannt aus der EP 1 195 584 A1.

Analyse- und Laborwaagen, insbesondere solche, die auf dem Prinzip der elektromagnetischen Kompensation arbeiten, sind allgemein bekannt. Ein elektromechanisches Wägesystem, d. h. ein typischerweise komplexes Hebelwerk mit einer eingangsseitigen Lastaufnahme und einer ausgangsseitigen Tauchspulenanordnung, ist dabei in einem Wägesystemraum angeordnet, der eine möglichst gute Abschirmung gegenüber Umgebungseinflüssen gewähren soll. Ein mit der Lastaufnahme verbundener Träger ragt in einen üblicherweise benachbarten Wägeraum hinein, der ebenfalls, nämlich durch seine Wägeraumwandung, weitgehend von der Umgebung abgeschirmt ist. Die Wägeraumwandung setzt sich üblicherweise aus dem Wägeraumboden, den Wägeraumdeckel, Wägeraumseitenwänden sowie eine Vorder- und Rückwand zusammen. Die Rückwand kann häufig mit einer Wand des Wägesystemraums zusammenfallen. Eine oder beide Seitenwände des Wägeraums sind häufig als bewegbare Windschutz-Elemente ausgebildet. Auch der Deckel und/oder die Vorderseite können, in der Regel verschließbare, Zugangsöffnungen enthalten. Die Kopplung des Trägers zur Lastaufnahme des Wägesystems durchsetzt üblicherweise die Rückwand oder den Boden des Wägeraums.

Weiter enthalten derartige Waagen stets eine Steuereinrichtung, die insbesondere die Wägesensorik ansteuert und dabei speziell die Tauchspulenanordnung des Wägesystems regelt. Allerdings können die Steuereinrichtungen moderner Waagen deutlich komplexer ausgestaltet sein und insbesondere verschiedene Betriebsvarianten des Systembetriebs zur Verfügung stellen. Solche Betriebsvarianten können die Steuerung der Sensorik oder einer Kühlvorrichtung betreffen, sie können sich jedoch alternativ oder zusätzlich auf die Ansteuerung bestimmter Hilfseinrichtungen im oder am Wägeraum beziehen. Rein beispielhaft seien eine Kühlvorrichtung, eine Windschutzsteuerung, Hebevorrichtungen innerhalb des Wägeraums, Beleuchtungseinrichtungen und ähnliches genannt.

Aus der eingangs genannten, gattungsbildenden Druckschrift ist es bekannt, solche Hilfseinrichtungen mit Wägefunktionsbezug in Form von Modulen, d. h. als wägefunktionsbezogene Module, kurz Funktionsmodule, vorzuhalten und im Wägeraum, insbesondere an dessen Rückwand, eine schienenartige Haltevorrichtung vorzusehen, welche unterschiedliche mechanische Schnittstellen aufweist, an welchen im konkreten Einzelfall benötigte Funktionsmodule in der jeweils benötigten Position festgelegt werden können. Mit anderen Worten sind besagte Funktionsmodule bedarfsweise in entsprechende Modulaufnahmen an der Wägeraumwandung einsetzbar. Ein solch modulares System ist insbesondere in Laborumgebungen vorteilhaft, in denen mit ein und derselben Waage unterschiedliche Wägeaufgaben durchgeführt werden müssen. Die Waage kann dann vom Benutzer selbst entsprechend seinem konkreten Bedarf im Einzelfall konfektioniert werden. Selbst in Fällen, in denen die mechanischen Schnittstellen so gestaltet sind, dass ein Modulaustausch durch den Benutzer unmöglich ist, sind solch modulare Systeme auch herstellerseitig vorteilhaft. Aufbauend auf demselben Waagengrundkörper können durch Wahl der in die Modulaufnahmen eingesetzten Funktionsmodule Waagen für unterschiedliche Wägeaufgaben vorkonfektioniert werden. Die Anzahl herzustellender Spezialteile verringert sich drastisch, was zu einer deutlichen Kosteneinsparung führt.

Problematisch bei diesem Konzept ist allerdings, dass solche Module, die Kombination mehrerer solcher Module sowie unterschiedliche Anbringungsorte innerhalb der Waage die metrologischen Eigenschaften der Waage nicht ändern dürfen. Einerseits wäre eine Verschlechterung der metrologischen Leistung für den Nutzer nicht hinnehmbar. Andererseits wären Änderungen der metrologischen Eigenschaften durch nicht rückwirkungsfreie Zusatzeinrichtungen, wie sie besagte Funktionsmodule darstellen können, für Systeme, die einer Zulassung bedürfen (Eichzulassung) auch gar nicht statthaft. Nicht rückwirkungsfreie Zusatzeinrichtungen und deren Kombinationen müssen, sofern Änderungen der metrologischen Eigenschaften zu befürchten sind, in einem aufwändigen Verfahren zugelassen werden. Es ist bekannt, dass das Einbringen von Wärmequellen in eine Waage, insbesondere in den Wägeraum ohne geeignete Gegenmaßnahmen zu einer derartigen, unerwünschten Änderung der metrologischen Eigenschaften führt.

Die nachveröffentlichte EP 3 557 199 A1 offenbart eine Waage mit einer aus mehreren Wandelementen zusammensetzbaren Wägeraum-Rückwand, deren Höhe auf diese Weise an unterschiedliche Windschutz-Höhen anpassbar ist, mithin Wägeräume unterschiedlicher Höhen aufbaubar sind.

Die EP 1 312 902 A1 offenbart eine Waage, an deren Wägeraum-Rückwand eine elektronische Zusatzeinheit, in welcher Versorgungseinheiten, bspw. eine Batterie, oder auch eine Steuerungselektronik angeordnet sein können, mithin ein Funktionsmodul im hiesigen Sinne, anbringbar ist. Die Druckschrift enthält keinerlei Hinweis auf die damit verbundene Problematik eines Wärmeeintrags in den Wägeraum.

Die EP 1 396 711 B1 offenbart eine Waage mit einem ohne jegliche Funktionsmodule ausgestatteten Wägeraum, die eine über ein thermoelektrisches Element vermittelte Wärmeabfuhr der Wägeelektronik und aus dem Wägeraum aufweist, wobei die spezielle thermische Ankopplung an die Wägeraum-Rückwand für die Ausbildung eines Temperaturgradienten innerhalb des Wägeraums sorgt.

Die DE 10 2014 101 561 A1 offenbart eine gravimetrische Dosiervorrichtung mit einem im Wägeraum angeordneten Klimamessmodul. Auf Basis der damit ermittelten Klimadaten können im Rahmen des Dosiervorgangs zu mischende Komponenten außerhalb der Vorrichtung vortemperiert werden.

Die DE 10 2009 055 624 A1 offenbart eine Waage mit einer in einem Gehäuseunterbau angeordneten Wägeelektronik, die mittels eines thermischen Abschirmblechs gegen insbesondere den Wägeraum abgeschirmt ist, wobei das Abschirmblech mit der kühlenden Seite eines thermoelektrischen Moduls verbunden ist.

Ein ähnlicher Ansatz wird in der JP 2 586 115 B2 verfolgt, wobei sich die thermisch abgeschirmte Wägeelektronik hier in einem Gehäuse hinter dem Wägeraum befindet.

Aus der DE 10 2014 101 585 A1 ist eine gravimetrische Messvorrichtung bekannt, umfassend
- eine Waage mit einem von einer Mehrzahl von Wägeraumwänden umgebenen Wägeraum, einem von einem angrenzenden Wägesystemraum umschlossenen, elektromechanischen Wägesystem und einer elektronischen Steuereinrichtung zur Steuerung des Systembetriebs gemäß in ihrem Speicher hinterlegten Regeln sowie
- ein als Klimamodul bezeichnetes, sensorisches Funktionsmodul zur Erfassung von im Wägeraum herrschenden Klimaparametern, welches bedarfsweise in eine an einer Wägeraumwand angeordnete Modulaufnahme einsetzbar ist,
wobei die Modulaufnahme eine geräteseitige Identifikationsschnittstellen-Komponente und das Funktionsmodul eine zu der geräteseitigen Identifikationsschnittstellen-Komponenten korrespondierende, modulseitige Identifikationsschnittstellen-Komponente aufweisen und wobei die Steuereinrichtung eingerichtet ist, das in die Modulaufnahme eingesetzte Funktionsmodul durch Wechselwirkung zwischen der jeweiligen geräte- und modulseitigen Identifikationsschnittstellen-Komponenten zu identifizieren.

### Aufgabenstellung

Es ist die Aufgabe der vorliegenden Erfindung, ein gattungsgemäßes gravimetrisches Messsystem derart weiterzubilden, dass ein flexibel an unterschiedliche Einsatzszenarien anpassbares und gleichwohl eichfähiges System resultiert.

### Darlegung der Erfindung

Diese Aufgabe wird in Verbindung mit den Merkmalen des Oberbegriffs von Anspruch 1 dadurch gelöst, dass die Modulaufnahmen
- thermisch untereinander sowie mit einer zentralen Kühlvorrichtung verbundene, geräteseitige Thermoschnittstellen-Komponenten sowie
- jeweils eine geräteseitige Identifikationsschnittstellen-Komponente aufweisen
   und die Funktionsmodule
- zu den geräteseitigen Thermoschnittstellen-Komponenten korrespondierende, modulseitige Thermoschnittstellen-Komponenten aufweisen, welche im eingesetzten Zustand des jeweiligen Funktionsmoduls die geräteseitige Thermoschnittstellen-Komponente der jeweils zugeordneten Modulaufnahme thermisch kontaktieren sowie
- jeweils eine zu den geräteseitigen Identifikationsschnittstellen-Komponenten korrespondierende modulseitige Identifikationsschnittstellen-Komponente
   aufweisen,

wobei die Steuereinrichtung eingerichtet ist, jedes in eine Modulaufnahme eingesetzte Funktionsmodul durch Wechselwirkung zwischen der jeweiligen geräte- und modulseitigen Identifikationsschnittstellen-Komponenten zu identifizieren und auf Grundlage von in ihrem Speicher hinterlegten Regeln eine von mehreren Betriebsvarianten auszuwählen,
und wobei die wenigstens eine Wägeraumwand, die ein Trennelement zwischen dem Wägeraum und dem Wägesystemraum bildet, als eine Trägerstruktur ausgebildet ist, die z.B. aus Pfosten und Streben aufgebaut ist, welche zwischen sich den überwiegenden Teil der Wandfläche freilassende, besagte Modulaufnahmen bildende Ausnehmungen definieren, die wägesystemraumseitig durch eine fest installierte Abschlusswand verschlossen und wägeraumseitig wahlweise durch jeweils räumlich an sie angepasste wägefunktionslose Blenden oder besagte Funktionsmodule verschließbar sind.

Bevorzugte Ausführungsformen sind Gegenstand der abhängigen Ansprüche.

Die Erfindung kombiniert mehrere Aspekte, die zwar technisch isoliert realisierbar sind, im Hinblick auf die o.g. Aufgabe der Eichfähigkeit aber in besonders vorteilhafter Weise wechselwirken.

Gemäß einem ersten Aspekt sieht die Erfindung vor, wenigstens diejenige Wägeraumwand, die die Trennwand zum Wägesystemraum darstellt, bevorzugt aber mehrere Wägeraumwände, als Gerippe- oder Gitterstruktur aufzubauen, welche mehrere, gleich gestaltete Ausnehmungen zum Einsetzen unterschiedlicher Funktionsmodule bietet. Aufgrund der gleichen Gestaltung dieser Modulaufnahmen können entsprechend gleich gestaltete, jedoch unterschiedlich wirksame Funktionsmodule an quasi beliebiger Stelle der Wägeraumwandung, insbesondere dort, wo sie gemäß aktuellem Bedarf benötigt werden, installiert werden. Die Gestaltung der Modulaufnahmen als Ausnehmungen erlaubt es zudem, zusätzliche Anschlüsse, auf die weiter unten noch eingegangen werden soll, außerhalb des Wägeraums zu positionieren, sodass sich im Wägeraum selbst nur die dort zwingend erforderlichen Komponenten befinden. Dies ist im Hinblick auf Sicherheit, Sauberkeit, Temperaturmanagement etc. von großer Bedeutung. Dieser erste Aspekt allein genügt jedoch hinsichtlich des Thermo-Managements einerseits und hinsichtlich der Wägesystemraum-Versiegelung andererseits noch nicht den Vorgaben an ein eichfähiges System.

Gemäß einem zweiten Aspekt sind daher wenigstens zwei Arten von Schnittstellen vorgesehen, die sich jeweils aus einer geräteseitigen und einer modulseitigen Schnittstellenkomponente zusammensetzen, die im in eine Modulaufnahme eingesetzten Zustand eines Funktionsmoduls miteinander in Wechselwirkung treten. Insbesondere handelt es sich hierbei um Thermo-Schnittstellen einerseits und Identifikations-Schnittstellen andererseits.

Mit den Identifikations-Schnittstellen sieht die Erfindung vor, dass die Trägerstruktur im Bereich wenigstens einer ihrer Ausnehmungen eine geräteseitige Identifikations-Schnittstellenkomponente aufweist, die beim Einsetzen eines Funktionsmoduls von einer korrespondierenden, modulseitigen Identifikations-Schnittstellenkomponente identifikationsdatenübertragend kontaktiert wird. Dabei können die geräteseitigen Identifikations-Schnittstellenkomponenten als optische, magnetische, taktile oder funktechnische Empfangseinheiten und die modulseitigen Identifikations-Schnittstellenkomponenten als korrespondierende optische, magnetische, taktile bzw. funktechnische Sendeeinheiten ausgebildet sein. Hintergrund dieser Maßnahmen ist die Schaffung einer Möglichkeit der automatischen Erkennung und Identifizierung der jeweils installierten Funktionsmodule. Insbesondere kann eine automatische Erkennung der Modulkonstellation durch die Steuereinheit der Waage vorgesehen sein.

Mit den Thermo-Schnittstellen sieht die Erfindung einen automatischen Anschluss der Funktionsmodule, d. h. der wechselnden Wärmequellen, an eine zentrale Kühlvorrichtung der Waage vor. Alle Modulaufnahmen, d. h. alle Positionen, an denen aktive, d. h. wärmegenerierende Funktionsmodule installiert werden können, sind mit geräteseitigen Thermo-Schnittstellenkomponenten bestückt, die allerdings lediglich im Bedarfsfall Einsatz finden, d. h. wenn tatsächlich ein Funktionsmodul mit korrespondierenden, modulseitigen Thermo-Schnittstellenkomponenten installiert wird. In Fällen, in denen kein Funktionsmodul in einer gegebenen Modulaufnahme installiert wird, bleibt die geräteseitige Thermo-Schnittstellenkomponente ohne Partner, d. h. unkontaktiert. Eine solche, nicht von einem aktiven Funktionsmodul besetzte Modulaufnahme kann mit einer Blende oder einem passiven, d. h. nicht wärmegenerierenden Funktionsmodul verschlossen werden. Dabei kann eine solche Blende bzw. ein solches passives Funktionsmodul gegebenenfalls mit geeigneten thermischen Isolationslementen ausgestattet sein, sodass die unkontaktierte geräteseitige Thermo-Schnittstellenkomponente keine die Temperaturverteilung im Wägeraum störende Kältequelle darstellt. Alternativ kann vorgesehen sein, dass die thermische Gesamtauslegung der Waage unter Berücksichtigung derartiger Kältequellen erfolgt, d. h. dass sich die gewünschte Temperaturverteilung im Wägeraum gerade bei unkontaktierten geräteseitigen Thermo-Schnittstellenkomponenten, also ohne installierte aktive Funktionsmodule, einstellt.

Bei Installation eines aktiven Funktionsmoduls erfolgt automatisch eine Kontaktierung der wechselseitigen Thermo-Schnittstellenkomponenten, sodass die Kühlvorrichtung die im Funktionsmodul generierte Wärme kompensierend abziehen kann. Eine solche Thermo-Schnittstelle kann beispielsweise in Form zweier, vorzugsweise gegeneinander federbelasteter, Metallplatten realisiert sein, von denen die eine thermisch an die Kühlvorrichtung und die andere thermisch an die Wärmequelle des Funktionsmoduls angeschlossen ist. Diese Platten sind relativ zueinander an der Waage, insbesondere im Bereich der Modulaufnahme, bzw. an dem Funktionsmodul derart positioniert, dass sie beim Einsetzen des Funktionsmoduls in die Modulaufnahme miteinander in, vorzugsweise federbelasteten, Kontakt kommen.

Gemäß einem dritten Aspekt der Erfindung ist eine spezielle Steuerung vorgesehen, die auf den zuvor erläuterten Schnittstellen gemäß dem zweiten Aspekt der Erfindung basiert. Diese Information zur Identität der eingesetzten Module kann nämlich zur Anpassung der Funktionssteuerung der Waage, insbesondere zur Kühlungssteuerung, verwendet werden. Die in der Steuereinrichtung vorgenommene Anpassung der Betriebsvariante an die jeweils detektierte Modulkonstellation kann allerdings sämtliche variierbaren Aspekte des Systembetriebs betreffen.

Bevorzugt ist dabei vorgesehen, dass die Steuereinrichtung eingerichtet ist, die Kühlvorrichtung mit einer von der Art und Anzahl der identifizierten Funktionsmodule abhängigen, statischen Grundkühlleistung anzusteuern. Bei einer solchen Ausführungsform kann weitgehend auf eine komplexe Temperaturregelung verzichtet werden. Es hat sich nämlich herausgestellt, dass, sofern die Waage an einem geeigneten Aufstellungsort ohne übermäßige Schwankungen von Umgebungsparametern aufgestellt ist, wie dies für Laborwaagen der Normalfall ist, ein Betrieb der Kühlvorrichtung mit einer statischen Kühlleistung, die hier als Grundkühlleistung angesprochen wird, ausreicht. Die erforderliche Grundkühlleistung ist jedoch von der konkreten Modulkonstellation abhängig. Dies gilt in ganz besonderem Maße in Fällen, in denen aktive Module, die eine positive Wärmeleistung in den Wägeraum einbringen, installiert sind. Beispiele hierfür sind Beleuchtungen, Anzeigen, Ionisatoren, Codescanner, motorische Elemente, wie Hebeeinrichtungen, etc.. Herstellerseitig sind die modulspezifischen Wärmeleistungen genau bekannt. Es kann sich hierbei um modulartspezifische oder sogar um modulindividuelle Werte handeln. Herstellerseitig lässt sich also im Speicher der Steuereinrichtung für jedes denkbarerweise installierbare Modul die zugeordnete Wärmeleistung hinterlegen bzw. ein zu ihrer Kompensation erforderlicher Kühlleistungsbetrag, um welchen die Grundkühlleistung erhöht wird, sobald die Installation des entsprechenden Moduls auf Basis der Identifikationsschnittstelle detektiert worden ist. Die Anpassung der Temperaturregulierung erfolgt daher durch statische Ansteuerung der Kühlvorrichtung und bedarf keiner aufwändigen Regelung.

Der Begriff des Speichers der Steuereinrichtung ist in diesem Zusammenhang ebenso wie der Begriff des Hinterlegens von Regeln und/oder Werten im Speicher weit zu verstehen. Er umfasst selbstverständlich lokale Speicher. Er ist jedoch auch auf externe Speicher, beispielsweise eine Cloud oder einen externen Server, zu beziehen. So soll es im Rahmen der vorliegenden Erfindung auch möglich sein, dass die Steuereinrichtung die ermittelte Modulkonstellation an eine externe Einheit, bspw. über Internet, übermittelt und von dort die konkreten Informationen zur Wahl der passenden Betriebsvariante erhält. Diese Ausführungsform der Erfindung hat den Vorteil, dass Informationen über neuentwickelte Module lediglich zentral hinterlegt werden müssen und nicht, bspw. über ein Firmware-Update, in jeder lokalen Steuereinrichtung aktualisiert werden müssen.

In diesem Kontext ist es besonders günstig, wenn jede geräteseitige Thermo-Schnittstellenkomponente eine geräteseitige Kontaktierungsfläche aufweist und die geräteseitigen Kontaktierungsflächen untereinander gleich groß sind und dass jede modulseitige Thermo-Schnittstellenkomponente eine modulseitige Kontaktierungsfläche aufweist und die modulseitigen Kontaktierungsflächen modulspezifisch unterschiedlich groß sind. Dabei kann insbesondere vorgesehen sein, dass die Größe jeder modulseitigen Kontaktierungsfläche gleich der oder kleiner als die Größe der geräteseitigen Kontaktierungsflächen und von der mittleren Betriebswärmeleistung des jeweiligen Funktionsmoduls abhängig ist. Mit anderen Worten ist bei dieser Weiterbildung also eine maximale Standardgröße der geräteseitigen Kontaktierungsflächen vorgesehen, wohingegen die modulseitigen Thermo-Schnittstellenkomponenten in der Regel kleiner und jedenfalls auf die Wärmeleistung ihrer Funktionsmodule abgestimmt sind. Dadurch wird nämlich von der Gesamtkühlleistung der Kühlvorrichtung, die ja aufgrund der gemeinsamen Kopplung und gleichen Ausgestaltung der geräteseitigen Kontaktflächen an den geräteseitigen Thermo-Schnittstellenkomponenten gleich verteilt anliegt, durch jedes Funktionsmodul nur ein solcher Bruchteil abgegriffen, wie er dem von dem jeweiligen Modul erzeugten Bruchteil an der Gesamtwärmeleistung entspricht. Module mit höherer Wärmeleistung erfahren also eine stärkere Kühlung; Module mit geringerer Wärmeleistung erfahren eine schwächere Kühlung.

Bei der bevorzugten Steuerung der Kühlvorrichtung, die statisch genau diejenige Gesamtkühlleistung liefert, die zur Kompensation der von den Funktionsmodulen eingebrachten Gesamtwärmeleistung erforderlich ist, ist günstigerweise vorgesehen, dass die Größen der modulseitigen Kontaktflächen derart aufeinander abgestimmt sind, dass jedes Funktionsmodul von der sich auf alle geräteseitigen Thermo-Schnittstellenkomponenten gleich verteilenden Kühlleistung den seine mittlere Betriebswärmeleistung kompensierenden Kühlleistungsbetrag abgreift. Dies kann insbesondere dadurch realisiert werden, dass die Größen der modulseitigen Kontaktflächen linear von der mittleren Betriebswärmeleistung des jeweiligen Funktionsmoduls abhängig sind. Beispielsweise kann die modulseitige Kontaktfläche eines Funktionsmoduls, welches die doppelte Wärmeleistung eines Referenzmoduls erzeugt, doppelt so groß sein wie die modulseitige Kontaktfläche des Referenzmoduls.

Ein vierter Aspekt der Erfindung betrifft schließlich die Versiegelung des Wägesystemraums. Das steht in scheinbarem Zielkonflikt mit der oben erläuterten Zugänglichkeit sämtlicher Schnittstellen und dem gitterartigen Aufbau der Wägeraumwand. Zur Überbrückung dieses Zielkonfliktes sieht die Erfindung daher vor, dass die Ausnehmungen der Trägerstruktur wägesystemraumseitig durch eine fest installierte Abschlusswand verschlossen sind. Mit anderen Worten wird die fragliche Wägeraumwand doppelschichtig ausgebildet. Zum Wägeraum hin sind die erfindungsgemäßen Ausnehmungen offen und weisen die vom Wägeraum her zugänglichen, geräteseitigen Schnittstellenkomponenten auf. Wägesystemraumseitig hingegen sind sämtliche Ausnehmungen durch eine nicht lösbare Wand verschlossen, sodass ein Durchgriff vom Wägeraum zum Wägesystemraum ausgeschlossen ist. Der Wägesystemraum bleibt damit versiegelt, sodass die Eichfähigkeit der Waage nicht beeinträchtigt ist. Gleichzeitig jedoch können die eingangs erläuterten Vorteile der Erfindung im Hinblick auf die Flexibilität bei der Konfektionierung voll genutzt werden.

Durch Zusammenwirkung sämtlicher vier Aspekte der Erfindung wird ein eichfähiges System geschaffen, dass im Hinblick auf die Flexibilität der bedarfsgerechten Waagenkonfektionierung den bekannten, nicht eichfähigen System in nichts nachsteht.

Weitere Merkmale und Vorteile der Erfindung ergeben sich aus der nachfolgenden speziellen Beschreibung und den Zeichnungen.

### Kurzbeschreibung der Zeichnungen

Es zeigen:
- Figur 1:: eine schematische Darstellung eines erfindungsgemäßen gravimetrischen Messsystems im Montageendzustand mit unvollständig dargestellter Wägeraumwandung,
- Figur 2:: die Wägeraumrückwand der Waage des gravimetrischen Messsystems von Figur 1 in einem Montagezwischenzustand ohne eingesetzte Funktionsmodule oder Blenden,
- Figur 3:: eine unvollständige Schnittdarstellung der Wägeraumrückwand der Waage des gravimetrischen Messsystems von Figur 1 und daran angrenzender Bereiche sowie
- Figur 4:: eine schematische Darstellung einer bevorzugten Kühlungssteuerung der Waage des gravimetrischen Messsystems von Figur 1.

### Beschreibung bevorzugter Ausführungsformen

Gleiche Bezugszeichen in den Figuren deuten auf gleiche oder analoge Elemente hin.

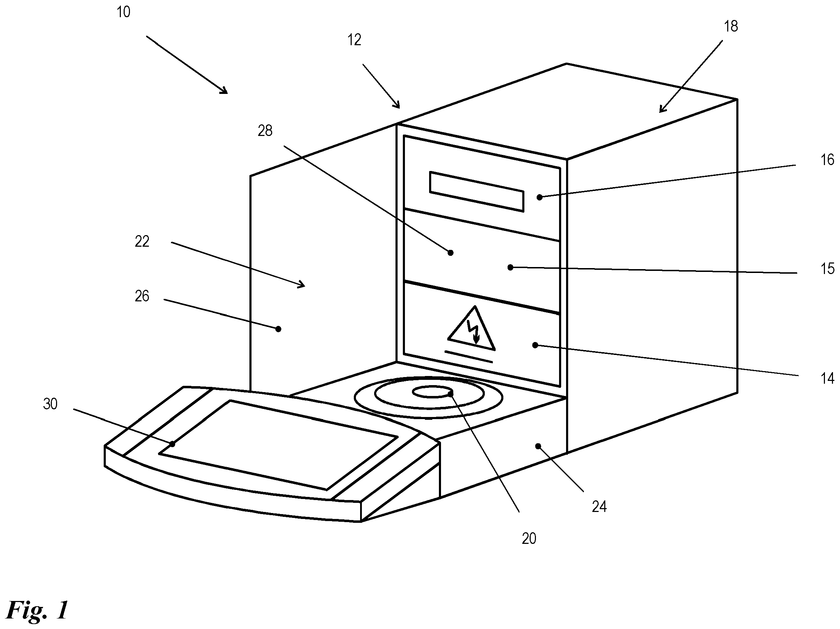

Figur 1 zeigt eine schematische Darstellung eines erfindungsgemäßen gravimetrischen Messsystems 10, welches im Wesentlichen aus einer Waage 12 und zwei darin eingesetzten Funktionsmodulen 14, 16 sowie einer Blende 15 besteht. Bei der gezeigten Ausführungsform ist das mit dem Bezugszeichen 14 versehene Funktionsmodul eine zur Erkennung von Barcodes geeignete Laserscannereinheit und das mit dem Bezugszeichen 16 versehene Funktionsmodul eine Beleuchtungseinheit. Die konkreten Funktionen der Funktionsmodule 14, 16 spielen im Kontext der vorliegenden Erfindung jedoch keine Rolle.

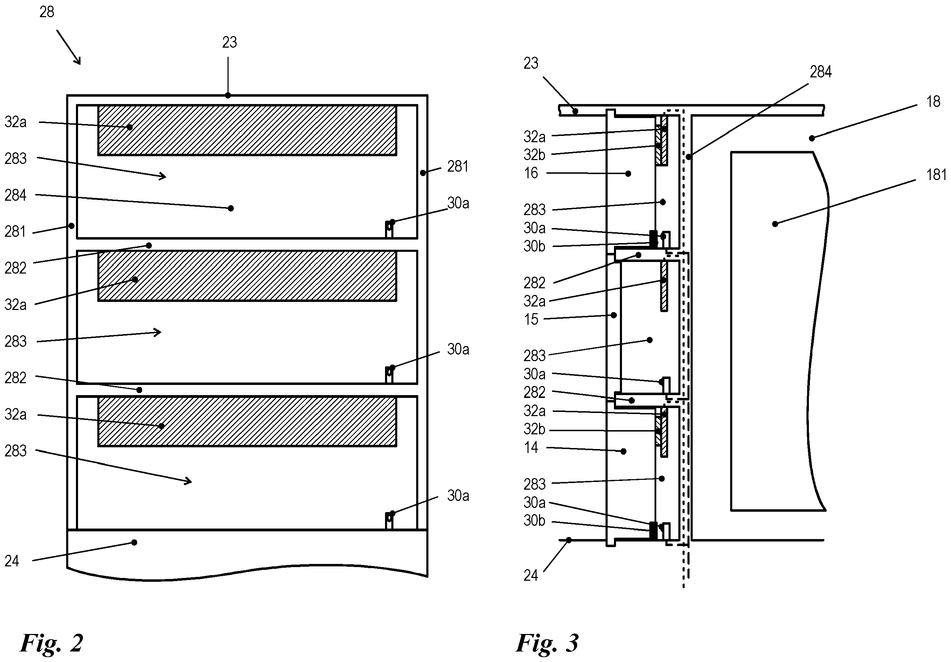

Die Waage 12 umfasst bei der gezeigten Ausführungsform im Wesentlichen drei Bereiche, nämlich einen Wägesystemraum 18, in dem ein in Figur 3 angedeutetes Wägesystem 181 angeordnet ist. Der konkrete Aufbau des Wägesystems 181 spielt im Kontext der vorliegenden Erfindung keine Rolle. Das Wägesystem 181 umfasst in jedem Fall eine nicht gesondert dargestellte Lastaufnahme, die mit einem Wägegutträger 20 verbunden ist, welcher seinerseits in einem bei der dargestellten Ausführungsform an den Wägesystemraum 18 angrenzenden Wägeraum 22 angeordnet ist. Der Wägeraum 22 ist von einer Wägeraumwandung umgeben, die in Figur 1 nur unvollständig dargestellt ist. Insbesondere sind der von dem Wägegutträger 20 durchsetzte Wägeraumboden 24, eine Wägeraumseitenwand 26 sowie eine Wägeraumrückwand 28, auf die weiter unten noch näher einzugehen sein wird, dargestellt. Die Wägeraumrückwand 28 ist bei der Darstellung von Figur 1 im Wesentlichen durch die Frontseiten der Funktionsmodule 14, 16 sowie die zwischen diesen Funktionsmodulen 14, 16 angeordnete Blende 15 verdeckt. Typischerweise umfasst die Wägeraumwandung zusätzlich eine weitere Wägeraumseitenwand, eine Wägeraumvorderwand und einen (nur in den Figuren 2 und 3 angedeuteten) Wägeraumdeckel 23, die aus Gründen der besseren Übersichtlichkeit in Figur 1 jedoch nicht dargestellt sind.

Weiter umfasst die Waage 12 eine Elektronikeinheit 30, die bei der gezeigten Ausführungsform im Wesentlichen eine großformatige Anzeige umfasst. Die Elektronikeinheit 30 kann zusätzlich eine Steuereinrichtung enthalten, auf die weiter unten noch näher einzugehen sein wird. Diese Steuereinrichtung kann jedoch auch an anderer Stelle der Waage 12 angeordnet sein. Als günstig wird angesehen, wenn diese Steuereinheit thermisch isoliert vom Wägesystemraum 18 sowie vom Wägeraum 22 angeordnet ist.

Figur 2 zeigt eine Frontalansicht der Wägeraumrückwand 28, allerdings ohne die eingesetzten Funktionsmodule 14, 16 und ohne die Blende 15. Figur 3 zeigt eine Schnittansicht der Wägeraumrückwand 28 und angrenzender Bereiche der Waage 12, wobei die Darstellung von Figur 3 allerdings auch die eingesetzten Funktionsmodule 14, 16, sowie die eingesetzte Blende 15 zeigt. Trotz dieses Unterschiedes erleichtert eine Zusammenschau der Figuren 2 und 3 das Verständnis der nachfolgenden Beschreibung.

Die Wägeraumrückwand 28 ist aus senkrechten Pfosten 281 und quer dazu angeordneten Streben 282 aufgebaut. Zwischen diesen erstrecken sich Ausnehmungen 283, die hier auch als Modulaufnahmen 283 bezeichnet werden.

Wägesystemraumseitig weist die Wägeraumrückwand 28 eine den Wägesystemraum 18 versiegelnde Abschlusswand 284 auf, die einen Durchgriff durch die Modulaufnahmen 283 in den Wägesystemraum 18 verhindert. Bei der dargestellten Ausführungsform ist die Abschlusswand 284 zugleich die Vorderwand des Wägesystemraums 18.

Die Modulaufnahmen 283 dienen der räumlich angepassten Aufnahme der Funktionsmodule 14, 16. In die in den Figuren 2 und 3 mittlere Modulaufnahme 283 ist bei der Ausführungsform der Figuren 1 und 3 kein Funktionsmodul eingesetzt. Diese Ausnehmung 283 zwischen den Pfosten 281 und Streben 282 ist durch die Blende 15 zum Wägeraum hin verschlossen. Die Modulaufnahmen 283 sind hinsichtlich ihrer nachfolgend näher zu beschreibenden Ausstattung identisch ausgebildet, sodass die Funktionsmodule 14, 16 ebenso wie andere, kompatibel ausgebildete Funktionsmodule in jede der Modulaufnahmen 283 einsetzbar sind. Hinsichtlich ihrer Größe sind die Modulaufnahmen 283 bevorzugt identisch, besonders bevorzugt ohne Trennelement ineinander übergehend ausgebildet, sodass Funktionsmodule 14, 16, deren Größe einem ganzzahligen Vielfachen einer Einheitsgröße entspricht, exakt in eine oder in mehrere einander benachbarte Modulaufnahmen 283 passend eingesetzt werden können. Denkbar ist auch, dass die Größen der Modulaufnahmen 283 selbst unterschiedliche ganzzahlige Vielfache einer Einheitsgröße sind. Gleiches wie für die Funktionsmodule 14, 16 gilt selbstverständlich auch für die Blenden 15.

Jede Modulaufnahme 283 verfügt über eine geräteseitige Identifikations-schnittstellenkomponente 30a, die mit einer korrespondierenden, modulseitigen Identifikations-Schnittstellenkomponente 30b eines eingesetzten Funktionsmoduls 14, 16 wechselwirken kann, um das eingesetzte Funktionsmodul 14, 16 zu identifizieren und über eine entsprechende Datenleitung (gestrichelte Linien) mit einer Steuereinheit zu verbinden.

Weiter weist jede Modulaufnahme 283 eine geräteseitige Thermo-Schnittstellenkomponente 32a auf, die mit einer korrespondierenden, modulseitigen Thermo-Schnittstellenkomponente 32b eines eingesetzten Funktionsmoduls 14, 16 in thermischem Kontakt steht. Die geräteseitigen Thermo-Schnittstellenkomponenten 32b sind untereinander sowie mit einer nicht dargestellten Kühlvorrichtung thermisch verbunden (punktierte Linien).

Weitere Schnittstellen, wie beispielsweise elektrische und datentechnische Schnittstellen zur Ansteuerung der Funktionsmodule 14, 16 sind zwar vorzugsweise vorgesehen, in den Figuren der Übersichtlichkeit halber nicht dargestellt.

Eine Besonderheit der modulseitigen Thermo-Schnittstellenkomponenten 32b der gezeigten Ausführungsform liegt darin, dass sie im Vergleich zu den geräteseitigen Thermo-Schnittstellenkomponenten 32a sowie untereinander unterschiedliche Kontaktflächengrößen aufweisen. Sämtliche modulseitigen Thermo-Schnittstellenkomponenten 32b sind kleiner als oder höchstens genauso groß wie die untereinander gleich großen, geräteseitigen Thermo-Schnittstellenkomponenten 32a. Die spezielle Größe der modulseitigen Kontaktflächen hängt von der Wärmeleistung der jeweiligen Funktionsmodule 14, 16 ab. Insbesondere kann eine Proportionalität zwischen der Wärmeleistung und der thermischen Kontaktflächengröße der Module bestehen.

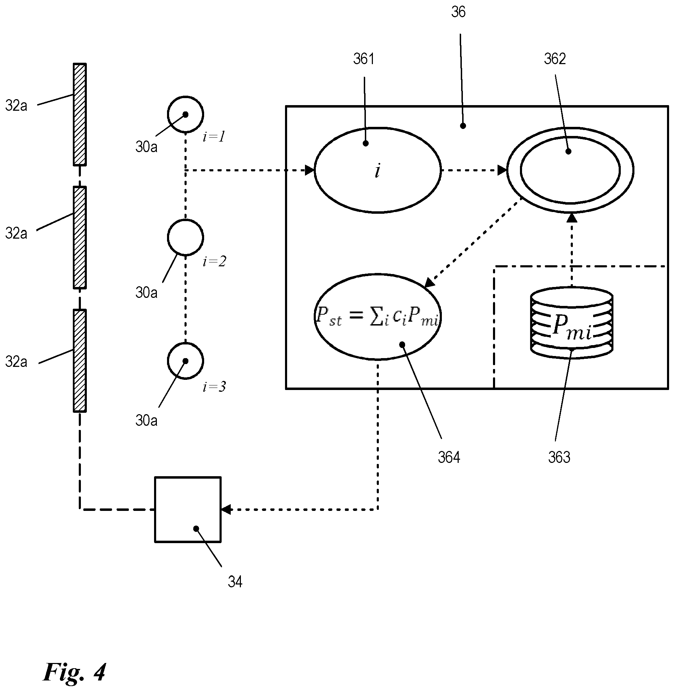

Figur 4 zeigt eine bevorzugte Ausführungsform einer Steuerung der Waage 12. Dargestellt sind die thermisch untereinander sowie mit einer Kühlvorrichtung 34 verbundenen, geräteseitigen Thermo-Schnittstellenkomponenten 32a sowie die geräteseitigen Identifikations-Schnittstellenkomponenten 30a, die hier jeweils mit dem Index i identifiziert sind. Die durch Wechselwirkung der geräteseitigen und modulseitigen Identifikations-Schnittstellenkomponenten 30a, b gewonnenen Identifikationsdaten, werden an eine Steuereinrichtung 36, dort insbesondere an die Identifikationseinheit 361 gesendet. Bei der in den Figuren 1 und 3 dargestellten Ausführungsform würde die Identifikations-Schnittstelle i=1 die Information über das eingesetzte Beleuchtungsmodul 16 liefern. Die Identifikations-Schnittstelle i=2 würde die Information über das Fehlen eines eingesetzten Funktionsmoduls liefern und die Identifikations-Schnittstelle i=3 würde die Information über das eingesetzte Laserscanner-Modul 14 liefern. Die Identifikation kann modultypspezifisch oder sogar modulindividuell erfolgen.

Die Identifikationsdaten werden von der Identifikationseinheit 361 an eine Zentraleinheit 362 gesendet. Diese erhält aus einer Speichereinheit 363 Informationen über die konkreten Wärmeleistungen der identifizierten Funktionsmodule 14, 16. Wie durch die strichpunktierte Linie angedeutet, kann die Speichereinheit 363 in die Steuereinrichtung 36 integriert oder entfernt davon, beispielsweise in einem über Internet angebundenen Server, vorgehalten sein. Allerdings kann diese Information auch in einer Speichereinheit des Funktionsmoduls selbst vorgehalten werden. Insbesondere kann vorgesehen sein, dass das Funktionsmodul nach seiner Fertigung werksseitig im Rahmen der Qualitätskontrolle eine individuelle Messung seiner Wärmeleistung durchläuft, deren Ergebnis dann in der Speichereinheit hinterlegt wird. Auch eine typenspezifische Hinterlegung ohne individuelle Messung ist möglich. In jedem Fall verbindet die Informationshinterlegung im Modul selbst die Vorteile der Entlastung der Waagen-Steuereinheit, der Unabhängigkeit von externen Datenquellen und der Möglichkeit der Individualisierung.

Aus den Identifikationsdaten einerseits und den Wärmeleistungsdaten andererseits berechnet die Zentraleinheit 362 die Vorgabewerte zur Ansteuerung der Kühlvorrichtung 34, die an eine mit der Kühlvorrichtung verbundene Kühlungssteuerungseinheit 364 weitergegeben werden. Bei der dargestellten Ausführungsform entspricht die vorgegebene Kühlleistung Pₛₜ einer statischen Kühlleistung, die sich aus der Summe der Einzelwärmeleistungen Pₘᵢ der identifizierten Funktionsmodule 14, 16, jeweils multipliziert mit einem Wichtungsfaktor cᵢ, zusammensetzt: *Pₛₜ* = Σ*ᵢ cᵢPₘᵢ*. Die Gesamtkühlleistung P ergibt sich in diesem Fall als Summe einer in Figur 4 nicht erwähnten, modulunabhängigen Grundkühlleistung P₀ und der modulabhängigen statischen Kühlleistung Pₛₜ : *P* = *P*₀ + *Pₛₜ* + *Pᵥ*

Mit dem Wichtungsfaktor cᵢ kann beispielsweise die spezielle Position, d.h. die spezielle Modulaufnahme, berücksichtigt werden, in der ein Funktionsmodul 14, 16 eingesetzt ist. Selbstverständlich kann auf eine solche Wichtung auch verzichtet werden, d.h. der Wichtungsfaktor entspricht dann 1 bzw. ist in allen Summanden identisch.

Diese statische Kühlleistung Pₛₜ wird von der Kühlvorrichtung 34 an sämtliche geräteseitigen Thermo-Schnittstellenkomponenten 32a gleich verteilt. Die jeweils bedarfsgerechte Verteilung an die Funktionsmodule 14, 16 erfolgt über die unterschiedlichen Größen der modulseitigen Thermo-Schnittstellenkomponenten 32b.

Bei einer Weiterbildung dieser Kühlungssteuerung bildet die statische Kühlleistung Pₛₜ nur einen von mehreren Termen der Gesamtkühlleistung P: *P* = *P*₀ + *Pₛₜ* + *Pᵥ* mit *Pᵥ* = *Pᵥ*(*T*). Bei dieser Ausführungsform ist zusätzlich zur statischen Kühlleistung Pₛₜ noch ein geringer, geregelter Kühlleistungsbeitrag, die Korrekturkühlleistung Pᵥ vorgesehen, mit dem geringe Schwankungen der Temperatur T im Wägeraum 22 kompensiert werden können.

Natürlich stellen die in der speziellen Beschreibung diskutierten und in den Figuren gezeigten Ausführungsformen nur illustrative Ausführungsbeispiele der vorliegenden Erfindung dar. Dem Fachmann ist im Lichte der hiesigen Offenbarung ein breites Spektrum von Variationsmöglichkeiten an die Hand gegeben. Insbesondere ist es möglich, alternativ oder zusätzlich zur Wägeraumrückwand 28 eine oder mehrere der übrigen Wände der Wägeraumwandung in der beschriebenen Weise als Pfosten/Streben-Struktur mit als Modulaufnahmen ausgebildeten Ausnehmungen zu gestalten. In solchen Fällen, in denen die Modulaufnahmen nicht an einen, insbesondere aus eichrechtlichen Gründen zu versiegelnden Raum grenzen, wird eine spezielle Versiegelungswand wie bei der hier gezeigten Ausführungsform nicht erforderlich sein.

### Bezugszeichenliste

- 10: gravimetrisches Messsystem
- 12: Waage
- 14: Funktionsmodul
- 15: Blende
- 16: Funktionsmodul
- 18: Wägesystemraum
- 181: Wägesystem
- 20: Wägegutträger
- 22: Wägeraum
- 23: Wägeraumdeckel
- 24: Wägeraumboden
- 26: Wägeraumseitenwand
- 28: Wägeraumrückwand
- 281: Pfosten
- 282: Strebe
- 283: Ausnehmung/Modulaufnahme
- 284: Abschlusswand
- 30a/b: geräteseitige/modulseitige Identifikations-Schnittstellenkomponente
- 32a/b: geräteseitige/modulseitige Thermo-Schnittstellenkomponente
- 34: Kühlvorrichtung
- 36: Steuereinrichtung
- 361: Identifikationseinheit
- 362: Zentraleinheit
- 363: Speichereinheit
- 364: Kühlungssteuerungseinheit
- P: Gesamtkühlleistung
- P₀: Grundkühlleistung
- Pᵥ: Korrekturkühlleistung
- cᵢ: Wichtungsfaktor
- Pₘᵢ: modulspezifische Wärmeleistung
- T: Temperatur (im Wägeraum)

## Patentansprüche

1. Gravimetrisches Messsystem (10), umfassend
- eine Waage (12) mit einem von einer Mehrzahl von Wägeraumwänden (23, 24, 26, 28) umgebenen Wägeraum (22), einem von einem angrenzenden Wägesystemraum (18) umschlossenen, elektromechanischen Wägesystem (181) und einer elektronischen Steuereinrichtung (36) zur Steuerung des Systembetriebs gemäß in ihrem Speicher (363) hinterlegten Regeln sowie
- eine Mehrzahl von bei Betrieb Wärme generierenden Funktionsmodulen (14, 16), die bedarfsweise in an wenigstens einer Wägeraumwand (28) angeordnete Modulaufnahmen (283) einsetzbar sind,
wobei die Modulaufnahmen (283)
- thermisch untereinander sowie mit einer zentralen Kühlvorrichtung (34) verbundene, geräteseitige Thermoschnittstellen-Komponenten (32a) sowie
- jeweils eine geräteseitige Identifikationsschnittstellen-Komponente (30a) aufweisen
und wobei die Funktionsmodule (14, 16)
- zu den geräteseitigen Thermoschnittstellen-Komponenten (32a) korrespondierende, modulseitige Thermoschnittstellen-Komponenten (32b) aufweisen, welche im eingesetzten Zustand des jeweiligen Funktionsmoduls (14, 16) die geräteseitige Thermoschnittstellen-Komponente (32a) der jeweils zugeordneten Modulaufnahme (283) thermisch kontaktieren sowie
- jeweils eine zu den geräteseitigen Identifikationsschnittstellen-Komponenten (30a) korrespondierende, modulseitige Identifikationsschnittstellen-Komponente (30b)
aufweisen,
wobei die Steuereinrichtung (36) eingerichtet ist, jedes in eine Modulaufnahme (283) eingesetzte Funktionsmodul (14, 16) durch Wechselwirkung zwischen der jeweiligen geräte- und modulseitigen Identifikationsschnittstellen-Komponenten (30a, b) zu identifizieren und auf Grundlage von in ihrem Speicher (363) hinterlegten Regeln eine von mehreren Betriebsvarianten auszuwählen,
und wobei die wenigstens eine Wägeraumwand (28), die ein Trennelement zwischen dem Wägeraum (22) und dem Wägesystemraum (18) bildet, als eine Trägerstruktur ausgebildet ist, welche den überwiegenden Teil der Wandfläche freilassende, besagte Modulaufnahmen bildende Ausnehmungen (283) aufweist, die wägesystemraumseitig durch eine fest installierte Abschlusswand (284) verschlossen und wägeraumseitig wahlweise durch jeweils räumlich an sie angepasste wägefunktionslose Blenden (14) oder besagte Funktionsmodule (14, 16) verschließbar sind.

2. Gravimetrisches Messsystem (10) nach Anspruch 1,
**dadurch gekennzeichnet,**
**dass** die Steuereinrichtung (36) eingerichtet ist, die Kühlvorrichtung (34) mit einer von der Art und Anzahl der identifizierten Funktionsmodule (14, 16) abhängigen, statischen Grundkühlleistung (P₀) anzusteuern.

3. Gravimetrisches Messsystem (10) nach Anspruch 2,
**dadurch gekennzeichnet,**
**dass** jede geräteseitige Thermoschnittstellen-Komponente (32a) eine geräteseitige Kontaktierungsfläche aufweist und die geräteseitigen Kontaktierungsflächen untereinander gleich groß sind
und **dass** jede modulseitige Thermoschnittstellen-Komponente (32b) eine modulseitige Kontaktierungsfläche aufweist und die modulseitigen Kontaktierungsflächen modulspezifisch unterschiedlich groß sind,
wobei die Größe jeder modulseitigen Kontaktierungsfläche gleich der oder kleiner als die Größe der geräteseitigen Kontaktierungsflächen und von der mittleren Betriebs-Wärmeleistung des jeweiligen Funktionsmoduls (14, 16) abhängig ist.

4. Gravimetrisches Messsystem (10) nach Anspruch 3,
**dadurch gekennzeichnet,**
**dass** die Größe jeder modulseitigen Kontaktierungsfläche derart von der mittleren Betriebs-Wärmeleistung des jeweiligen Funktionsmoduls (14, 16) abhängig ist, dass jedes Funktionsmodul (14, 16) von der sich auf alle geräteseitigen Thermoschnittstellen-Komponenten (32a) gleich verteilenden Kühlleistung (P) den seine mittlere Betriebswärmeleistung kompensierenden Kühlleistungsbetrag abgreift.

## Claims

1. Gravimetric measuring system (10), comprising
- a balance (12) having a weighing chamber (22) surrounded by a plurality of weighing chamber walls (23, 24, 26, 28), an electromechanical weighing system (181) enclosed by an adjoining weighing system chamber (18), and an electronic control apparatus (36) for controlling operation of the system in accordance with rules stored in a memory (363) of the electronic control apparatus, and
- a plurality of functional modules (14, 16) which generate heat during operation and which can be inserted as required into module receptacles (283) arranged on at least one weighing chamber wall (28),
wherein the module receptacles (283) have
- device-side thermal interface components (32a) which are thermally connected to one another and to a central cooling apparatus (34), and
- in each case a device-side identification interface component (30a),
and wherein the functional modules (14, 16) have
- module-side thermal interface components (32b) corresponding to the device-side thermal interface components (32a), which in the inserted state of the respective functional module (14, 16) come into thermal contact with the device-side thermal interface component (32a) of the respectively associated module receptacle (283), and
- in each case a module-side identification interface component (30b) corresponding to the device-side identification interface components (30a),
wherein the control apparatus (36) is designed to identify each functional module (14, 16) inserted in a module receptacle (283) through interaction between the respective device-side and module-side identification interface components (30a, b) and to select one of a plurality of operating variants on the basis of rules stored in the memory (363) of the control apparatus,
and wherein the at least one weighing chamber wall (28), which forms a separating element between the weighing chamber (22) and the weighing system chamber (18), is designed as a support structure having recesses (283) which form said module receptacles and which leave the majority of the wall surface free, which recesses are closed on the weighing system chamber side by a fixedly installed end wall (284) and can be closed on the weighing chamber side optionally by panels (14), which are spatially adapted thereto and have no weighing function, or by said functional modules (14, 16).

2. Gravimetric measuring system (10) according to claim 1,
**characterized**
**in that** the control apparatus (36) is designed to actuate the cooling apparatus (34) with a static basic cooling output (P₀) which depends on the type and number of the identified functional modules (14, 16).

3. Gravimetric measuring system (10) according to claim 2,
**characterized**
**in that** each device-side thermal interface component (32a) has a device-side contact area and the device-side contact areas are each of equal size, and
**in that** each module-side thermal interface component (32b) has a module-side contact area and the module-side contact areas are of different sizes specific to the module,
wherein the size of each module-side contact area is equal to or smaller than the size of the device-side contact areas and depends on the average operating heat output of the respective functional module (14, 16).

4. Gravimetric measuring system (10) according to claim 3,
**characterized**
**in that** the size of each module-side contact area depends on the average operating heat output of the respective functional module (14, 16) such that each functional module (14, 16) taps off from the cooling output (P) distributed equally across all device-side thermal interface components (32a) the amount of cooling output that compensates its average operating heat output.

## Revendications

1. Système de mesure gravimétrique (10), comprenant
- une balance (12) avec un espace de pesée (22) entouré par une pluralité de parois d'espace de pesée (23, 24, 26, 28), un système de pesée électromécanique (181) entouré par un espace de système de pesée (18) adjacent et un dispositif de commande (36) électronique pour la commande du fonctionnement du système conformément aux règles enregistrées dans sa mémoire (363) ainsi que
- une pluralité de modules fonctionnels (14, 16) générant de la chaleur lors du fonctionnement, qui peuvent être insérés si besoin est dans des logements de modules (283) disposés sur au moins une paroi d'espace de pesée (28),
dans lequel les logements de modules (283) présentent
- des composants d'interface thermique côté appareil (32a) reliés thermiquement les uns aux autres ainsi qu'à un dispositif de refroidissement central (34) ainsi que
- respectivement un composant d'interface d'identification côté appareil (30a)
et dans lequel les modules fonctionnels (14, 16) présentent
- des composants d'interface thermique côté module (32b) correspondant aux composants d'interface thermique côté appareil (32a), lesquels dans l'état inséré du module fonctionnel (14, 16) respectif sont en contact thermique avec le composant d'interface thermique côté appareil (32a) du logement de module (283) respectivement associé ainsi que
- respectivement un composant d'interface d'identification côté module (30b) correspondant aux composants d'interface d'identification côté appareil (30a),
dans lequel le dispositif de commande (36) est conçu pour identifier chaque module fonctionnel (14, 16) inséré dans un logement de module (283) par interaction entre les composants d'interface d'identification côté appareil et module (30a, b) respectifs et pour sélectionner une de plusieurs variantes de fonctionnement sur la base des règles enregistrées dans sa mémoire (363),
et dans lequel la au moins une paroi d'espace de pesée (28), qui forme un élément de séparation entre l'espace de pesée (22) et l'espace de système de pesée (18), est réalisée sous la forme d'une structure de support, laquelle présente des évidements (283) formant lesdits logements de modules laissant ouverte la majeure partie de la surface de paroi, qui sont fermés côté espace de système de pesée par une paroi de fermeture (284) installée fixement et peuvent être fermés côté espace de pesée sélectivement par respectivement des panneaux (14) exempts de fonction de pesée adaptés à ceux-ci dans l'espace ou lesdits modules fonctionnels (14, 16).

2. Système de mesure gravimétrique (10) selon la revendication 1,
**caractérisé en ce**
**que** le dispositif de commande (36) est conçu pour commander le dispositif de refroidissement (34) avec une puissance de refroidissement de base (P₀) statique, dépendant du type et nombre des modules fonctionnels (14, 16) identifiés.

3. Système de mesure gravimétrique (10) selon la revendication 2,
**caractérisé en ce**
**que** chaque composant d'interface thermique côté appareil (32a) présente une surface de mise en contact côté appareil et les surfaces de mise en contact côté appareil sont de même taille entre elles
et **que** chaque composant d'interface thermique côté module (32b) présente une surface de mise en contact côté module et les surfaces de mise en contact côté module sont de taille différente de manière spécifique au module,
dans lequel la taille de chaque surface de mise en contact côté module est inférieure ou égale à la taille des surfaces de mise en contact côté appareil et dépend de la puissance thermique de fonctionnement moyenne du module fonctionnel (14, 16) respectif.

4. Système de mesure gravimétrique (10) selon la revendication 3,
**caractérisé en ce**
**que** la taille de chaque surface de mise en contact côté module dépend de la puissance thermique de fonctionnement moyenne du module fonctionnel (14, 16) respectif, de telle sorte que chaque module fonctionnel (14, 16) prélève de la puissance de refroidissement (P) se répartissant de manière égale sur tous les composants d'interface thermique côté appareil (32a) la valeur de puissance de refroidissement compensant sa puissance de chauffage calorifique moyenne.
